# EUROPEAN PATENT APPLICATION

(11) **EP 2 942 190 A1**
(43) Date of publication of application: **11.11.2015**
(21) Application number: 15170818.7
(22) Date of filing: 02.03.2012
(51) Int. Cl.: B32B 15/088, C08L 79/08, C08J 5/24, C08L 101/00, H05K 1/03, H01L 23/14, C08K 3/00, C08G 73/10

(54) **Resin composition for printed-wiring board**

(30) Priority: 07.03.2011 JP 2011049423
(62) Divisional of application: 12755400.4
(71) Applicant: MITSUBISHI GAS CHEMICAL COMPANY, INC., Chiyoda-ku, Tokyo 100-8324 (JP)
(72) Inventor: Oomori, Takabumi, Fukushima, 961-8031 (JP); Hasebe, Keiichi, Tokyo, 125-8601 (JP)
(74) Representative: Hoffmann Eitle

(57) **Abstract**

A resin composition is provided which comprises a polyimide resin, a thermosetting resin, and a filler, wherein the ratio of the thermosetting resin to the total content of the resin composition excluding the filler is between 10 and 90 % by weight. The polyimide resin contains a first repeat unit represented by formula (I) and a second repeat unit represented by formula (III), wherein the ratio of the second repeat unit to the polyimide resin is between 5 and 80 mol%.

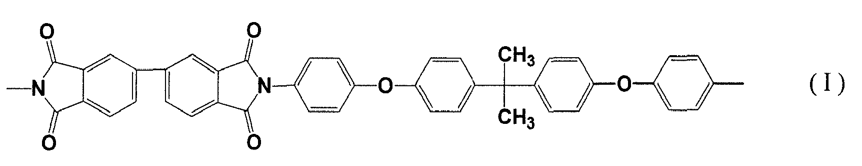

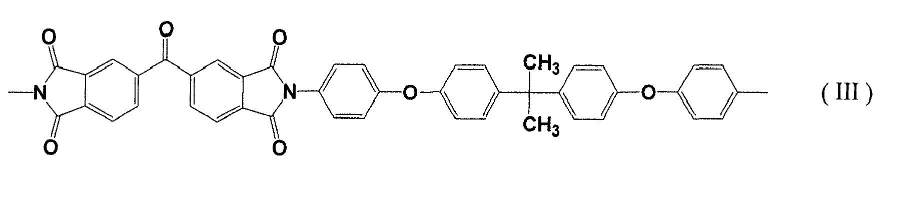

## Description

### [Technical Field]

The present invention relates to a resin composition and, more specifically, to a resin composition suitable for a printed-wiring board, as well as to a metallic foil-clad laminate and a printed-wiring board using the same.

### [Background Art]

In recent years, smaller, thinner and lighter electronics have been demanded, and the need for printed-wiring boards with higher density is also increasing. Densification of printed-wiring boards requires forming finer circuits. Conventional methods for forming circuits include subtractive method, in which a metallic foil is etched to form a circuit, and (semi)additive method, in which a conducting layer is formed on an insulating layer by plating.

For the subtractive method, a metallic foil having a remarkably uneven matte surface is used to provide better adhesion to the insulating layer. When fine circuits are formed, projecting parts are prone to remain on the resin surface of the laminate due to the remarkable unevenness of the matte surface. In order to remove such projections from the resin surface, it is necessary to carry out etching for a longer period of time. However, there is a problem in that complete removal of the residual projections may bring about over etching of circuits, causing deterioration in positional accuracy and adhesion strength of circuits.

On the other hand, according to the (semi)additive method, in order to secure adhesion between the insulating layer and the conducting layer, the insulating layer surface is roughened to increase surface unevenness before subjected to plating. However, there is a problem in that such increased surface unevenness may cause deterioration in accuracy of forming fine circuits (see, e.g., Patent Documents 1 and 2).

In addition, polyimide for use as a resin for metallic foil-clad wiring boards is often poorly-soluble to organic solvents and has difficulty in being made into varnish. Further, a metallic foil-clad laminate using polyimide often has a problem in that when the metallic foil is etched and the conducting layer is formed thereon by plating, it exhibits poor thermal resistance under moisture absorption, causing swell of the plate due to heating after moisture absorption. Moreover, in order to secure sufficient adhesion strength between the insulating layer and the conducting layer, the copper foil (matte) surface is required to have a certain degree of unevenness, making it difficult to reduce the roughness of the substrate surface. Accordingly, careful selection of copper foil is needed (see Patent Document 3).

Thus, there is a demand for a resin which is highly soluble and easily handleable, can provide good adhesion to the conducting layer even when the surface roughness is low, and exhibits high thermal resistance under moisture absorption.

### PRIOR ART DOCUMENTS

### PATENT DOCUMENTS

Patent document 1: JP2003-069218A
Patent document 2: JP2003-249751A
Patent document 3: JP2008-254352A

### [Disclosure of the Invention]

### [Problems to Be Solved by the Invention]

The object of the present invention is to provide a resin composition for use in printed-wiring boards which is highly soluble and easily handleable, can provide good adhesion to the conducting layer even when the surface roughness is low, and exhibits high thermal resistance under moisture absorption, being suitable for forming fine circuits thereon.

### [Means for Solving the Problems]

Having examined a resin composition for use in printed-wiring boards which contains a polyimide resin, a thermosetting resin and a filler, the present inventors have found that when a certain thermosetting resin is used in a definite amount, the resultant resin composition becomes highly soluble, can provide good adhesion to the conducting layer even when the surface roughness is low, and exhibits high thermal resistance under moisture absorption, whereby printed-wiring boards suitable for fine circuits can be obtained. The present invention has been achieved based on the above finding.

Thus, the present invention provides a resin composition comprising a polyimide resin, a thermosetting resin, and a filler, the polyimide resin containing a first repeat unit represented by formula (I) and a second repeat unit represented by formula (II) or (III), wherein when the second repeat unit is represented by formula (II), the ratio of the second repeat unit to the polyimide resin is between 5 and 35 mol%, and when the second repeat unit is represented by formula (III), the ratio of the second repeat unit to the polyimide resin is between 5 and 80 mol%.

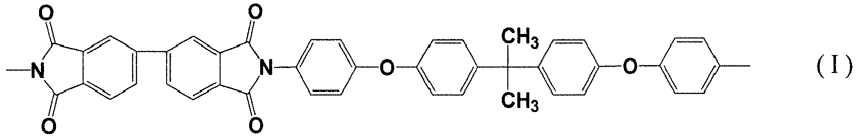

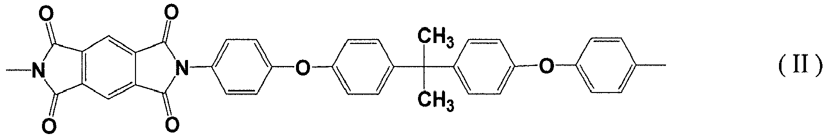

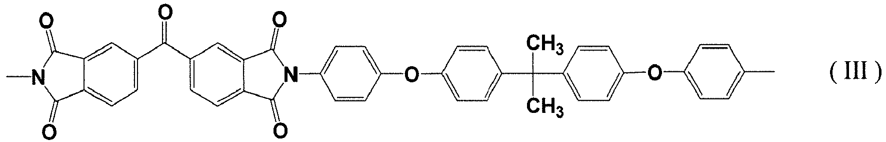

The present invention also provides a prepreg comprising a woven or non-woven fabric impregnate with the above resin composition.

The present invention further provides a metallic foil-clad laminate comprising an insulating layer containing the above resin composition, and a metallic foil placed over at least one surface of the insulating layer.

The present invention also provides a printed-wiring board comprising an insulating layer containing the above resin composition and a conducting layer placed over at least one surface of the insulating layer.

### [Effects of the Invention]

The resin composition according to the present invention has at least one of the following effects:
(1) It is highly soluble and easily handleable;
(2) It can provide good plate/copper adhesion even when the surface roughness is low.
(3) It exhibits high thermal resistance under moisture absorption.

Thanks to the effects of items (1) to (3) above, the resin composition of the present invention is suitable for use as a resin in high-density printed-wiring boards.

### [Best Mode for Carrying out the Invention]

The resin composition according to the present invention contains a polyimide resin, a thermosetting resin, and a filler as requisite ingredients. Ingredients constituting the resin composition according to the present invention will be explained below. In this context, when the ratio of a certain repeat unit in a resin is indicated with "mol%," it means the ratio of the repeating number of the certain repeat unit to the total repeating number of all repeat units in the resin.

### <Polyimide resin>

The polyimide resin used in the resin composition of the present invention contains a first repeat unit represented by formula (I) and a second repeat unit represented by either formula (II) or formula (III).

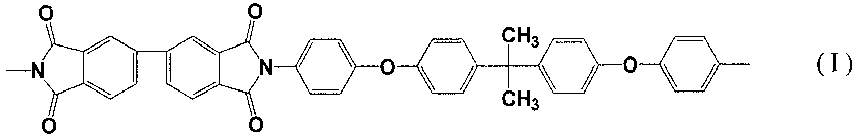

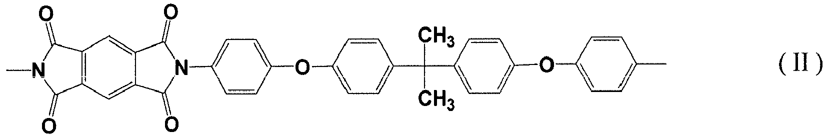

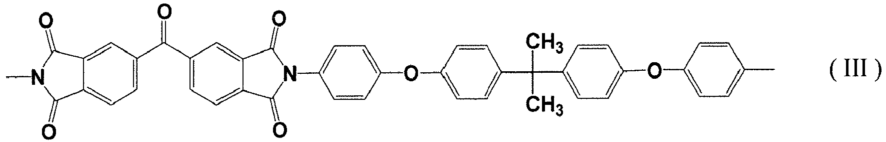

Thus, the polyimide resin used for the present invention may be either a polyimide resin containing the first repeat unit represented by formula (I) and the second repeat unit represented by formula (II) (hereinafter also called "polyimide resin A") or a polyimide resin containing the first repeat unit represented by formula (I) and the second repeat unit represented by formula (III) (hereinafter also called "polyimide resin B"). The polyimide resins A and B may be used either singly or in combination at any ratios. In the following description, the polyimide resins A and B may collectively be called "the polyimide resin of the present invention."

The ratio of the second repeat unit represented by formula (II) in the polyimide resin A is usually 5 mol% or more, preferably 7 mol% or more, and usually 35 mol% or less, preferably 30 mol% or less, to the whole polyimide resin.

The ratio of the second repeat unit represented by formula (III) in the polyimide resin B is usually 5 mol% or more, preferably 7 mol% or more, and usually 80 mol% or less, preferably 70 mol% or less, more preferably 60 mol% or less, to the whole polyimide resin.

If the ratio of the second repeat unit in the polyimide resin A or B is lower than the lower limit stated above, desired effects (e.g., improved adhesion and thermal resistance under moisture absorption) may not be obtained. On the other hand, if the ratio of the second repeat unit in the polyimide resin A or B is higher than the upper limit stated above, desired effects (e.g., improved solubility) may not be obtained.

With regard to the solubility of the polyimide resin of the present invention, assuming that N-methyl-2-pyrrolidone (NMP) is used as a solvent, the solubility of the polyimide resin of the present invention should be five parts or more to 100 parts of NMP by mass, as long as the ratio of the second repeat unit represented by formula (II) or (III) is within the range stated above. If the solubility of the polyimide resin of the present invention is lower than stated above, when it is made into varnish in combination with a thermosetting resin and a filler, the resultant varnish can have only a low solid content concentration and offer poor workability when used in production of printed-wiring board materials.

With regard to the form of polymerization, the polyimide resin of the present invention may be either a block copolymer (which contains a block consisting mainly of the first repeat unit and a block consisting mainly of the second repeat unit) or a random copolymer (which contains the first repeat unit and the second repeat unit arranged at random), although a random copolymer is preferred in view of ease of production.

The polyimide resin of the present invention may either consist only of the first and second repeat units or further contain one or more additional repeat units (hereinafter also called "the third repeat unit").

However, in order to achieve desired effects (e.g., improved solubility, adhesion with metal, and thermal resistance under moisture absorption), the polyimide resin of the present invention should preferably consist substantially of the first and second repeat units, while the ratio of the third repeat unit, if any, should preferably be as low as possible. Specifically, it is preferred that the total ratio of the first and second repeat units to the polyimide resin of the present invention should usually be 60 mol% or more, particularly 80 mol% or more, more particularly 90 mol% or more, still more particularly 95 mol% or more.

In addition, in order to achieve excellent chemical resistance (resistance to chemicals such as acids or alkalis), which is required for the insulating layer of a printed-wiring board, the ratio of repeat units containing siloxane bond (-Si-O-Si-) (hereinafter also called "siloxane repeat unit") should preferably be as low as possible. Specifically, it is preferred that the total ratio of siloxane repeat units to the polyimide resin of the present invention should usually be less than 20 mol%, particularly 10 mol% or less, more particularly 3 mol% or less.

The structure and ratio of each repeat unit in a polyimide resin can be determined by analyzing the structure of the resin using a known analysis method such as nuclear magnetic resonance (NMR). Alternatively, the structure and ratio of each repeat unit in a polyimide resin can be estimated based on the structures and ratios of tetracarboxylic dianhydride and diamine used in the production of the resin.

The polyimide resin of the present invention can be produced by, e.g., reacting tetracarboxylic dianhydride with diamine. Specifically, for the polyimide resin A, preferred tetracarboxylic dianhydrides include 3,4,3',4'-biphenyltetracarboxylic dianhydride and pyromellitic dianhydride, and preferred diamines include 2,2-bis{4-(4-aminophenoxy)phenyl}propane. For the polyimide resin B, preferred tetracarboxylic dianhydrides include 3,4,3',4'-biphenyltetracarboxylic dianhydride and 3,3',4,4'-benzophenone tetracarboxylic dianhydride, and preferred diamines include 2,2-bis{4-(4-aminophenoxy)phenyl}propane. Known isomers of 3,4,3',4'-biphenyltetracarboxylic dianhydride, pyromellitic dianhydride, 3,3',4,4'-benzophenone tetracarboxylic dianhydride and 2,2-bis{4-(4-aminophenoxy)phenyl}propane can also be used.

The polyimide resin of the present invention which further contains a third repeat unit can be produced by, e.g., using one or more tetracarboxylic dianhydrides and/or diamines at appropriate ratios in accordance with the structure of the desired third repeat.

The reaction ratio between the diamine component and the tetracarboxylic acid component should theoretically be such that one mol of diamine component to one mol of tetracarboxylic acid component. However, the actual ratio of these components should preferably be modified as appropriate, depending on, e.g., the properties of the diamine and tetracarboxylic acid components and the reaction conditions. Specifically, the tetracarboxylic acid component can be used in a ratio of preferably between 0.66 and 1.5 mol, more preferably between 0.9 and 1.1 mol, still more preferably between 0.97 and 1.03 mol, to one mol of diamine component.

The terminals of the polyimide resin of the present invention may be reacted with an endcapping agent such as an acid anhydride or amine, in order to avoid reaction with a thermosetting resin or to control molecular mass. Introduction of a functional group with low polarity to the molecular ends may serve to lower the water absorption of the resultant printed-wiring board. Examples of endcapping agents include acid anhydrides such as phthalic anhydride, maleic anhydride, and nadic anhydride, and amines such as p-methylaniline, p-methoxyaniline, and p-phenoxyaniline.

The polyimide resin of the present invention may usually be produced as a solution in a solvent. Examples of solvents include, but are not limited to, NMP, N,N-dimethylacetamide, N,N-diethylacetamide, N,N-dimethylformamide, N,N-diethylformamide, N-methylcaprolactam, hexamethylphosphoramide, tetramethylenesulfone, dimethylsulfoxide, m-cresol, phenol, p-chlorphenol, 2-chlor-4-hydroxytoluene, diglyme, triglyme, tetraglyme, dioxane, γ-butyrolactone, dioxolan, cyclohexanone, and cyclopentanone. These solvents may also be used in combination of two or more at any ratios. Preferable solvents among these are NMP, N,N-dimethylacetamide, and γ-butyrolactone, which can be used either singly or in combination of two or more at any ratios. NMP allows the polyimide resin of the present invention to dissolve well, and therefore can be used preferably. The amount of the solvent should be determined as appropriate such that the concentration of the polyimide resin of the present invention in the solution should preferably be between 1% and 50% by weight, more preferably between 5% and 40% by weight. When the resin is produced by solution polymerization, the above solvent may be used in combination with a poor solvent such as hexane, heptane, benzene, toluene, xylene, chlorbenzene, and o-dichlorobenzene, in such an amount that does not cause precipitation of the polymerization product.

Methods for producing the polyimide resin of the present invention may be any conventional methods and include, but are not limited to: solution polymerization; a method in which a polyamic acid solution is prepared and made into the form of a film followed by imidization; a method in which a salt (e.g., half-ester salt) or an imide oligomer of a tetracarboxylic dianhydride is prepared and subjected to solid-phase polymerization; and a method in which a tetracarboxylic dianhydride is reacted with a diisocyanate. Two or more of these methods may also be used in combination. The reaction between the tetracarboxylic acid component and the diamine component may be carried out in the presence of a conventional catalyst such as acids, tertiary amines, or acid anhydrides. The most preferred method for the present invention among the aforementioned methods is solution polymerization, since it can directly produce a solution of the polyimide resin of the present invention.

Specific procedures for producing the polyimide resin of the present invention by solution polymerization are as follows. The diamine component is mixed in a solvent, optionally with a catalyst as required, by stirring at 10 to 600 rpm to prepare a homogeneous solution, to which the tetracarboxylic acid component is added, optionally with a catalyst when required, at a temperature of between 30°C and 90°C to prepare a reaction solution. Alternatively, the tetracarboxylic acid component is mixed in an organic solvent, optionally with a catalyst as required, by stirring at 10 to 600 rpm to prepare a homogeneous solution, to which the diamine component is added, optionally with a catalyst when required, at a temperature of between 30°C and 90°C to prepare a reaction solution. The temperature of the reaction solution is elevated such that it reaches between 160°C to 230°C in a period of 0.1 to 6 hours. The reaction system is then maintained substantially at a constant temperature for 0.1 to 24 hours, preferably for 0.5 to 12 hours, while components leaking out from the reaction system are collected. The reaction system is then cooled to a proper temperature, optionally by adding an organic solvent as necessary, to yield the polyimide resin of the present invention. The elevated temperature can be determined as appropriate based on the boiling point of the organic solvent, being preferably between 170°C and 210°C.

The solution polymerization may be carried out in the presence of at least one catalyst selected from tertiary amine compounds such as trimethylamine, triethylamine, tripropylamine, tributylamine, triethanolamine, N,N-dimethylethanolamine, N,N-diethylethanolamine, triethylenediamine, N-methylpyrrolidine, N-ethylpyrrolidine, N-methylpiperidine, N-ethylpiperidine, imidazole, pyridine, quinoline, and isoquinoline. The amount of the catalyst to be used should preferably be between 0.1 and 100 mol%, more preferably between 1 and 10 mol%, to the tetracarboxylic acid component.

The molecular mass of the polyimide resin of the present invention should usually be between 2,000 and 100,000, preferably between 4,000 and 100,000, more preferably between 8,000 and 80,000, on the number-average molecular mass (Mn) basis, and also should be usually between 10,000 and 500,000, preferably between 20,000 and 400,000, more preferably between 50,000 and 300,000, on the weight-average molecular mass (Mw) basis. The molecular mass of the polyimide resin should not be below the lower limit mentioned above in view of improving thermal resistance under moisture absorption, and should not exceed the upper limit mentioned above in view of achieving better solubility.

The number-average molecular mass (Mn) and the mass-average molecular mass (Mw) of a resin can be determined by known methods including gel permeation chromatography (GPC), size exclusion chromatography (SEC), and matrix-assisted laser desorption/ionization mass spectrometry (MALDI-MS).

The content of the polyimide resin of the present invention in the resin composition according to the present invention should preferably be between 5% and 90% by weight, in particular between 10% and 80% by weight, to the amount of the resin composition excluding the filler, in view of improving adhesion with metal and thermal resistance under moisture absorption. As mentioned above, the polyimide resin of the present invention may be either the polyimide resin A or the polyimide resin B, or may be a combination of both at any ratios. If both the polyimide resin A and the polyimide resin B are used, the total ratio of the polyimide resins A and B should preferably satisfy the range stated above.

### <Thermosetting resin>

The thermosetting resins used for the resin composition of the present invention include maleimide compounds, epoxy resins, phenol resins, and cyanate resins.

Maleimide compounds include, but are not limited to, bis(4-maleimide phenyl)methane, polyphenylmethane maleimide, m-phenylene bismaleimide, bisphenol A diphenylether bismaleimide (2,2'-bis[4-(4-maleimide phenoxy)phenyl]propane), 3,3'-dimethyl-5,5'-diethyl-4,4'-diphenylmethane bismaleimide, and 4-methyl-1,3-phenylene bismaleimide. Two or more of such maleimide compounds may also be used in combination as appropriate. A suitable maleimide compound for the present invention among these is bisphenol A diphenylether bismaleimide (2,2'-bis[4-(4-maleimide phenoxy)phenyl]propane). Prepolymers of maleimide compounds as well as prepolymers of maleimide compounds and amine compounds may also be used.

Epoxy resins include, but are not limited to, bisphenol A type epoxy resins, bisphenol F type epoxy resins, phenol novolac type epoxy resins, cresol novolac type epoxy resins, trifunctional phenol type epoxy resins, tetrafunctional phenol type epoxy resins, phenol aralkyl type epoxy resins, biphenylaralkyl type epoxy resins, alicyclic epoxy resins, naphthalene type epoxy resins, and partially brominated products of these epoxy resins. Two or more of such epoxy resins may also be used in combination as appropriate.

As phenol resins, any conventional phenol resins can be used without limitation. Examples include bisphenol A type phenol resins, bisphenol F type phenol resins, phenol novolac resins, cresol novolac resins, trifunctional phenol resins, tetrafunctional phenol resins, phenol aralkyl resins, biphenylaralkyl type phenol resins, and naphthol type resins. Partially brominated products of these phenol resins can also be used. Two or more of such phenol resins can also be used in combination as appropriate. Preferable resins for the present invention among these are biphenylaralkyl type phenol resins and naphthol type resins.

As cyanate resins, any conventional cyanate resins can be used without limitation. Examples include 2,2'-bis(4-cyanate phenyl)propane, 2,2'-bis(4-cyanate phenyl)ethane, 2,2'-bis(4-cyanate-3,5-methylphenyl)ethane, aralkyl type cyanate, and novolac type cyanates. Two or more of such cyanate resins can also be used in combination as appropriate. Preferable resins for the present invention among these are novolac type cyanates. These cyanate resins may also be used as monomers or made in the form of prepolymers. Prepolymers can be prepared by heating a monomer solution to a temperature of between 50°C and 200°C in the presence or absence of a catalyst. Catalysts which can be used for forming prepolymers include: acids such as mineral acids and Lewis acids; bases such as sodium alcoholate and tertiary amines; salts such as sodium carbonate; and active hydrogen-containing compounds such as bisphenol compounds and monophenol compounds.

The content of the thermosetting resin in the resin composition of the present invention should preferably be between 10% and 90% by weight, in particular between 20% and 80% by weight, to the amount of the resin composition excluding the filler, in view of improving adhesion with metal and thermal resistance under moisture absorption.

### <Filler>

As the filler for the resin composition of the present invention, any conventional fillers can be used without any limitation. Examples of such fillers are inorganic fillers including: silicas such as natural silica, molten silica, amorphous silica, fumed silica, and hollow silica; metal hydroxides such as aluminum hydroxide, heated products of aluminum hydroxide (prepared by heating aluminum hydroxide to partly remove crystallization water), boehmite, and magnesium hydroxide; molybdenum compounds such as molybdenum oxide and zinc molybdate; titanium oxide; barium titanate; barium sulfate; zinc borate; zinc stannate; alumina; clay; kaolin; talc; calcined clay; calcined kaolin; calcined talc; mica; short glass fiber (glass fine powder such as E glass and D glass); hollow glass; and whisker. Other examples are organic fillers including: rubber powders such as styrene types, butadiene types, and acrylic types; core-shell type rubber powders; silicone resin powders; silicone rubber powders; and silicone composite powders. In view of improving thermal resistance under moisture absorption, preferable fillers for the present invention are silicas, aluminum hydroxide, heated products of aluminum hydroxide (prepared by heating aluminum hydroxide to partly remove crystallization water), and boehmite, which may be used either singly or in combination of any two or more at any ratios.

With regard to the particle diameter of the filler, the median particle diameter (also called "d50") should preferably be 4µm or less, still more preferably 2µm or less, in view of improving the homogeneity when the resin composition is used in the insulating layer of a printed-wiring board.

The content of the filler in the resin composition according to the present invention should preferably be between 1% and 60% by weight, more particularly between 5% and 40% by weight, to the resin composition. If the content of the filler is within the range stated above, plate adhesion when the conducting layer is formed by plating on the surface of the insulating layer containing the resin composition can be balanced with adhesion with metal. In addition, the resin composition according to the present invention can suitably be used in, e.g., a metallic foil-clad laminate. If the metallic foil-clad laminate is subjected to, e.g., hole-making procedure using carbon dioxide laser, the content of the filler in the resin composition should preferably be 10% or more by weight to the resin composition, in order to improve shapes of the holes.

### <Other components>

In addition to the polyimide resin, the thermosetting resin, and the filler mentioned above, the resin composition of the present invention may further contain one or more additional components.

For example, the resin composition may contain a dispersant in order to uniformly disperse the filler in the resin composition. In addition, in order to improve the interface adhesion between the filler and the resin, a coupling agent (e.g., a silane coupling agent) may effectively be used for treating the filler surface, or added to the resin in an appropriate amount.

The resin composition of the present invention can be cured by heat even without any curing catalyst. However, a curing catalyst can be used in order to reduce the period of time required for curing. A curing catalyst can be chosen as appropriate, depending on the properties of the thermosetting resin. Examples include, but are not limited to: organic metal salts such as zinc octylate, tin octylate, and dibutyl tin dimaleate; acetylacetone iron; chlorides such as aluminum chloride, tin chloride, and zinc chloride; amines such as triethylenediamine and dimethylbenzylamine; imidazoles such as 2-methylimidazole and 2-ethyl-4-methylimidazole; and phenols such as phenol and catechol. These curing catalysts may be used either singly or in combination of two or more. The curing catalyst may be used in an amount of between about 0.001 and about 5 parts by mass to the resin composition.

### <Effects of resin composition>

The resin composition according to the present invention exhibits at least one, preferably all, of the following effects (1) to (3):
(1) The resin composition of the present invention is highly soluble and easily handleable, and can easily be made into resin varnish for printed-wiring boards.
(2) The resin composition of the present invention can offer good adhesion with metal, and can be adhered with a metallic foil whose matte surface has undergone only a limited roughening treatment (i.e., whose matte surface has only small unevenness) or a metallic foil which has not undergone roughening treatment. In addition, it can offer good adhesion with the conducting layer formed by plating even when the resin surface has only limited unevenness. Thus, it is advantageous in forming fine circuits by the (semi)additive method.
(3) The resin composition of the present invention is excellent in thermal resistance under moisture absorption, and can avoid the problem of swelling of the plate conducting layer due to heating after moisture absorption.

Thanks to the effects (1) to (3) above, the resin composition of the present invention can suitably be used as a resin material for high-density printed-wiring boards, especially as a resin material for forming an insulating layer.

### <Prepreg>

The resin composition according to the present invention may be cured and used singly as an insulating layer of a printed-wiring board or, if necessary, may be reinforced with woven or non-woven fabric. For example, fibrous reinforcement made of woven or non-woven fabric impregnated with the resin composition according to the present invention is heated to form a prepreg. Fibrous reinforcement may be any woven or non-woven fabric made of, e.g.: glass fibers such as E, NE, D, S, and T glasses; inorganic fibers such as quartz glass fiber, carbon fiber, alumina fiber, silicon carbide fiber, asbestos, rock wool, slag wool, and plaster whisker; and organic fibers such as wholly aromatic polyamide fiber, polyimide fiber, liquid-crystal polyester, and polyester fiber.

A prepreg can be produced by a method including, e.g., impregnating or coating fibrous reinforcement with the resin composition, followed by heating in a drier at a temperature of between 100°C and 200°C for one to 60 minutes to cause semi-curing and to prepare a prepreg.

The resin composition according to the present invention may be applied to a surface of, e.g., copper foil, release film (such as PET film), or commercial polyimide film by coating, and then dried to prepare resin composition-clad copper foil, resin composition-clad release film, or resin composition-clad polyimide film, respectively, which can be used as an insulating material for printed-wiring boards.

### <Metallic foil-clad laminate>

The metallic foil-clad laminate according to the present invention is a metallic foil-clad laminate including an insulating layer using the resin composition of the present invention, and a metallic foil arranged on at least either surface of the insulating layer. The metallic foil-clad laminate may further include, as an inner layer, a substrate including pre-formed circuits (inner layer core) as necessary.

The metallic foil-clad laminate according to the present invention may be usually produced by a known method for producing a metallic foil-clad laminate or a metallic foil-clad laminate containing inner layer circuits. For example, it can be produced by preparing a sheet of the resin composition, or laminating two or more such sheets, inserting an inner layer core at an appropriate position if necessary, and forming metallic foil on either or both sides of the laminate, followed by laminate press. The resin composition used for producing the sheet metallic foil-clad laminate may be in the form of a sheet made of resin composition either with or without a woven or non-woven fabric reinforcement.

The conditions for laminate press may be conventional conditions usually used for printed-wiring board materials. Typical conditions are: using a multiplaten press machine, a multiplaten vacuum press machine, or an autoclave molding machine, heating is carried out for 0.05 to 5 hours at a temperature between 100°C and 300°C and under a pressure of between about 0.02 N/mm² and about 1.0 N/mm² (between 2 Kgf/cm² and 100 Kgf/cm²). Other production methods include: a method in which either side of a metallic foil is coated with the resin composition, which is thermally cured to form a one-side metallic foil-clad laminate; and a method in which either side of a metallic foil is coated with the resin composition to form a metallic foil with semi-cured resin, on the resin side of which another metallic foil with or without semi-cured resin is placed and subjected to laminate pressing for integration. A metallic foil-clad laminate with inner layer circuits may also be produced by preparing a metallic foil with semi-cured resin containing the resin composition, placing it on each side of an inner layer core, and subjecting the laminate to integral pressing.

As copper foil for metallic foil-clad laminate, any conventional copper foil used for printed-wiring boards can be used without any limitation. Preferable examples include electrolytic copper foil, rolled copper foil, and such foils of alloy containing copper. Copper foil may have undergone conventional surface treatment such as nickel treatment and cobalt treatment. The thickness of the copper foil can be selected as appropriate depending on the uses thereof, preferably being 70µm or less.

Due to its good adhesion with metal, the resin composition according to the present invention is applicable to a metallic foil whose matte surface has undergone only a limited roughening treatment (i.e., whose matte surface has only small unevenness) or a metallic foil which has not undergone roughening treatment. The surface roughness (Rz) of the copper foil surface should preferably be 4µm or less, more preferably 2µm or less. In this context, Rz means 10-point average roughness defined under JIS B0601.

### <Printed-wiring board>

The printed-wiring board according to the present invention is produced by preparing an insulating layer made of the resin composition of the present invention and forming a conducting layer on the surface of the insulating layer by plating. According to the present invention, since the insulating layer is formed by curing the resin composition mentioned above, good adhesion can be achieved between the conducting layer and the insulating layer. The conducting layer can be formed by plating using any known method, such as additive method, semiadditive method, and full additive method. Examples of such methods include: a method including removing the surface metallic foil of a metallic foil-clad laminate by etching, carrying out roughening treatment if necessary, and forming the conducting layer by plating; and a method including placing a sheet of the resin composition on each side of an inner layer core, pressing them to form an integrated laminate, carrying out roughening treatment on the surface of the laminate if necessary, and forming the conducting layer by plating.

An example of pattern forming by semiadditive method includes: forming a thin conducting layer on the surface insulating layer by, e.g., non-electrolytic plating; carrying out electrolytic plating selectively with plating resist (pattern plating); removing the plating resist; and etching the whole surface as appropriate to form a pattern. Another example of pattern forming by full additive method includes: forming a pre-pattern on the surface insulating layer with plating resist in advance, and selectively adding a non-electrolytic plating to form a pattern. Pattern forming can also be made by forming a conducting layer on the surface insulating layer by plating, and then selectively removing the conducting layer with etching resist.

When a conducting layer is formed by plating, roughening treatment may also be carried out on the surface insulating layer as necessary. Roughening treatment can be carried out by dry method, wet method, or combination thereof. Specific examples of wet methods include roughening treatments using chemicals such as alkaline permanganate solution; oxidant solutions such as dichromates, ozones, hydrogen peroxide/sulfates, and nitrates; or strong alkaline solutions. Specific examples of dry methods include roughening treatments by mechanical polishing using, buff and sandblast, and roughening treatments using plasma etching.

Methods for forming a conducting layer on the surface insulating layer by plating include dry plating method and wet plating method. Examples of dry plating include various conventional methods such as vapor deposition, sputtering, and ion plating, while examples of wet plating include conventional methods such as non-electrolytic plating and a combination of non-electrolytic plating and electrolytic plating. Among these methods, the combination of non-electrolytic plating and electrolytic plating is preferred, and an especially preferable method is to form a conducting layer by carrying out roughening treatment of the surface insulating layer as necessary, and then carrying out non-electrolytic plating, followed by electrolytic plating to form a conducting layer. In this method, it is preferred to dry the product after non-electrolytic plating in order to remove the water content. Conditions for drying after non-electrolytic plating may be any conditions as long as the water content can be removed. For example, heating at a temperature of between 100°C and 170°C for one to five hours is sufficient to remove the water content and also to improve the adhesion between the surface conducting layer and the insulating layer. In addition, heating at a temperature of between 150°C and 200°C for 20 to 90 minutes after pattern forming serves to improve and stabilize the adhesion between the surface conducting layer and the insulating layer further.

### [EXAMPLES]

The present invention will be explained in more details by referring to the Examples below. However, the present invention is not limited by the following Examples. Unless indicated otherwise, the term "parts" means the parts by mass in the solid content, and the concentrations are indicated with percentages by weight.

### <Synthesis of polyimides>

### Synthetic Exmaple 1

A four-necked 1000ml flask equipped with stainless-steel agitating blades, nitrogen duct, a Dean-Stark with cooling tube, and a thermometer was loaded with 41.06g (100mmol) of 2,2-bis{4-(4-aminophenoxy)phenyl}propane (hereinafter called BAPP), 100g of NMP, 12g of toluene, and 0.51g of triethylamine, and the content was agitated at 100 rpm under a nitrogen atmosphere. To the resultant solution, 2.18g (10mmol) of pyromellitic dianhydride (hereinafter called PMDA), 26.48g (90mmol) of 3,4,3',4'-biphenyltetracarboxylic dianhydride (hereinafter called BPDA), and 100g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for 30 minutes, after which the temperature in the reaction system was decreased to approximately 130°C. The reaction system was then mixed with 415.0g of NMP under agitation to form a homogenous solution, and air-cooled to almost reach room temperature, whereby a solution of Polyimide 1 with a solid content concentration of about 10% was produced. Polyimide 1 had a number-average molecular mass (Mn) of 2.08×10⁴ and a mass-average molecular mass (Mw) of 1.2×10⁵ according to GPC measurement.

### Synthetic Exmaple 2

A four-necked 1000ml flask equipped with stainless-steel agitating blades, nitrogen duct, a Dean-Stark with cooling tube, and a thermometer was loaded with 32.85g (80mmol) of BAPP, 80g of NMP, 6g of toluene, and 0.41g of triethylamine, and nitrogen under atmosphere , 100 rpm the content was agitated at 100 rpm under a nitrogen atmosphere. To the resultant solution, 5.23g (24mmol) of PMDA, 16.48g (56mmol) of BPDA, and 80g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for 30 minutes, after which the temperature in the reaction system was decreased to approximately 130°C. The reaction system was then mixed with 405.0g of NMP under agitation to form a homogenous solution, and air-cooled to almost reach room temperature, whereby a solution of Polyimide 2 with a solid content concentration of about 10% was produced. Polyimide 2 had a number-average molecular mass (Mn) of 1.92×10⁴ and a mass-average molecular mass (Mw) of 1.10×10⁵ according to GPC measurement.

### Comparative Synthetic Exmaple 1

A four-necked 1000ml flask equipped with stainless-steel agitating blades, nitrogen duct, a Dean-Stark with cooling tube, and a thermometer was loaded with 32.85g (80mmol) of BAPP, 80g of NMP, 6g of toluene, and 0.41g of triethylamine, and the content was agitated at 100 rpm under a nitrogen atmosphere. To the resultant solution, 23.50g (80mmol) of BPDA and 80g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for 30 minutes, after which the temperature in the reaction system was decreased to approximately 130°C. The reaction system was then mixed with 405.0g of NMP under agitation to form a homogenous solution, and air-cooled to almost reach room temperature, whereby a solution of Comparative Polyimide 1 with a solid content concentration of about 10% was produced. Comparative Polyimide 1 was poorly soluble to a solvent and became semisolid, having a problem in handleability. Comparative Polyimide 1 had a number-average molecular mass (Mn) of 1.68.08×10⁴ and a mass-average molecular mass (Mw) of 7.15×10⁴ according to GPC measurement.

### Comparative Synthetic Exmaple 2

A four-necked 1000ml flask equipped with stainless-steel agitating blades, nitrogen duct, a Dean-Stark with cooling tube, and a thermometer was loaded with 34.22g (83.3mmol) of BAPP, 83.33g of NMP, 10g of toluene, and 0.433g of triethylamine, and the content was agitated at 100 rpm under a nitrogen atmosphere. To the resultant solution, 18.17g (83.3mmol) of PMDA was added, and the mixture was agitated at room temperature for one hour, and heated in oil bath for about 20 minutes until the temperature in the reaction system reaches 180°C. Distilled components were captured while the temperature in the reaction system was maintained at 180°C for 30 minutes. When the temperature in the reaction system almost reached 180°C, formed polyimide precipitated in the reaction system as yellow powder. The reaction system was then mixed with 294g of NMP under agitation at around 130°C for about 30 minutes, whereby a solution of Comparative Polyimide 2 with a solid content concentration of about 10% was produced. Comparative Polyimide 2 was very poorly soluble to a solvent and did not form a homogeneous solution even after agitation, having a problem in handleability.

### Comparative Synthetic Exmaple 3

A four-necked 1000ml flask equipped with stainless-steel agitating blades, nitrogen duct, a Dean-Stark with cooling tube, and a thermometer was loaded with 41.06g (100mmol) of BAPP, 100g of NMP, 12g of toluene, and 0.51g of triethylamine, and the content was agitated at 100 rpm under a nitrogen atmosphere. To the resultant solution, 8.72g (40mmol) of PMDA, 17.65g (60mmol) of BPDA, and 100g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for 30 minutes, after which the temperature in the reaction system was decreased to approximately 130°C. The reaction system was then mixed with 395.0g of NMP under agitation at around 130°C for about 30 minutes, whereby a solution of Comparative Polyimide 3 with a solid content concentration of about 10% was produced. Comparative Polyimide 3 very poorly soluble to a solvent and did not form a homogeneous solution even after agitation, having a problem in handleability.

### Synthetic Exmaple 3

A four-necked 1000mol flask equipped with stainless-steel agitating blades, nitrogen duct, a Dean-Stark with cooling tube, and a thermometer was loaded with 32.85g (80mmol) of BAPP, 80g of NMP, 6g of toluene, and 0.41g of triethylamine, and the content was agitated at 100 rpm under a nitrogen atmosphere. To the resultant solution, 7.73g (24mmol) of 3,3',4,4'-benzophenone tetracarboxylic dianhydride (hereinafter called BTDA), 16.48g (56mmol) of BPDA, and 80g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for 30 minutes, after which the temperature in the reaction system was decreased to approximately 130°C. The reaction system was then mixed with 347g of NMP under agitation to form a homogenous solution, and air-cooled to almost reach room temperature, whereby a solution of Polyimide 3 with a solid content concentration of about 10% was produced. Polyimide 3 had a number-average molecular mass (Mn) of 1.82×10⁴ and a mass-average molecular mass (Mw) of 7.54×10⁴ according to GPC measurement.

### Synthetic Exmaple 4

A four-necked 1000ml flask equipped with stainless-steel agitating blades, nitrogen duct, a Dean-Stark with cooling tube, and a thermometer was loaded with 32.85g (80mmol) of BAPP, 80g of NMP, 6g of toluene, and 0.41g of triethylamine, and the content was agitated at 100 rpm under a nitrogen atmosphere. To the resultant solution, 12.89g (40mmol) of BTDA, 11.77g (40mmol) of BPDA, and 80g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for one hour, after which the temperature in the reaction system was decreased to approximately 130°C. The reaction system was then mixed with 352g of NMP under agitation to form a homogenous solution, and air-cooled to almost reach room temperature, whereby a solution of Polyimide 4 with a solid content concentration of about 10% was produced. Polyimide 4 had a number-average molecular mass (Mn) of 3.73×10⁴ and a mass-average molecular mass (Mw) of 2.28×10⁵ according to GPC measurement.

### Comparative Synthetic Exmaple 4

A four-necked 500ml flask equipped with stainless-steel agitating blades, nitrogen duct, a Dean-Stark with cooling tube, and a thermometer was loaded with 20.53g (50mmol) of BAPP, 50g of NMP, 6g of toluene, and 0.26g of triethylamine, and the content was agitated at 100 rpm under a nitrogen atmosphere. To the resultant solution, 16.11g (50mmol) of BTDA and 50g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for one hour, after which the temperature in the reaction system was decreased to approximately 130°C. The reaction system was then mixed with 220g of NMP under agitation to form a homogenous solution, and air-cooled to almost reach room temperature, whereby a solution of Comparative Polyimide 4 with a solid content concentration of about 10% was produced. Comparative Polyimide 4 was poorly soluble to a solvent and became semisolid after left overnight in the form of solution at room temperature, having a problem in handleability.

### Comparative Synthetic Exmaple 5

A four-necked 500ml flask equipped with stainless-steel agitating blades, nitrogen duct, a Dean-Stark with cooling tube, and a thermometer was loaded with 20.53g (50mmol) of BAPP, 50g of NMP, 6g of toluene, and 0.26g of triethylamine, and the content was agitated at 100 rpm under a nitrogen atmosphere. To the resultant solution, 14.50g (45mmol) of BTDA, 1.47g (5mmol) of BPDA, and 50g of NMP were added each in a mass, and the mixture was agitated at room temperature for one hour, and heated in oil bath for about 20 minutes until the temperature in the reaction system reaches 180°C. Distilled components were captured while the temperature in the reaction system was maintained at 180°C for one hour, after which the temperature in the reaction system was decreased to approximately 130°C. The reaction system was then mixed with 220g of NMP under agitation to form a homogenous solution, and air-cooled to almost reach room temperature, whereby a solution of Comparative Polyimide 5 with a solid content concentration of about 10% was produced. Comparative Polyimide 5 was poorly soluble to a solvent and became semisolid after left overnight in the form of solution at room temperature, having a problem in handleability.

The constitutions and the status of resin solutions of the polyimide resins produced in Synthetic Examples 1 to 4 and Comparative Synthetic Examples 1 to 5 above (Polyimides 1 to 4 and Comparative Polyimides 1 to 5) are indicated in Table 1 below.

**[Table 1]**

| Polyimide resin | Resin components | | | | Status of Resin solution |
|---|---|---|---|---|---|
| | Amine component | (mol%) | Dicarboxylic acid component(s) | (mol%) | |
| Polyimide 1 | BAPP | 100 | PMDA | 10 | Homogenous solution |
| | | | BPDA | 90 | |
| Polyimide 2 | BAPP | 80 | PMDA | 24 | Homogenous solution |
| | | | BPDA | 56 | |
| Polyimide 3 | BAPP | 80 | BTDA | 24 | Homogenous solution |
| | | | BPDA | 56 | |
| Polyimide 4 | BAPP | 80 | BTDA | 40 | Homogenous solution |
| | | | BPDA | 40 | |
| Comparative Polyimide 1 | BAPP | 80 | BPDA | 80 | Semisolid solution |
| Comparative Polyimide 2 | BAPP | 83.3 | PMDA | 83.3 | Inhomogeneous solution |
| Comparative Polyimide 3 | BAPP | 100 | PMDA | 40 | Inhomogeneous solution |
| | | | BPDA | 60 | |
| Comparative Polyimide 4 | BAPP | 50 | BTDA | 50 | Semisolid solution |
| Comparative Polyimide 5 | BAPP | 50 | BTDA | 45 | Semisolid solution |
| | | | BPDA | 5 | |

### <Preparation of resin compositions and production of copper-clad laminates>

### Example 1

NMP was mixed with 0.53 part of dispersant (Disperbyk W903, manufactured by BYK Chemie Japan KK) under agitation. The mixture was then combined with 70 parts of boehmite with an average particle diameter of 0.6µm as a filler, and agitated for 30 minutes with a homomixer, whereby Filler Solution A with a solid content of 20% was prepared. Separately, NMP was combined with 0.5 parts of dispersant (BYK161, manufactured by BYK Chemie Japan KK) and three parts of fumed silica (R202, manufactured by Nippon Aerosil Co., Ltd.) as a filler, and agitated for 30 minutes with a homomixer, whereby Filler Solution B with a solid content of 5% was prepared.

A mixture of Filler Solution A and Filler Solution B above was combined with 50 parts of Polyimide 1 prepared in Synthetic Exmaple 1 and 50 parts of maleimide compound 2,2'-bis[4-(4-maleimide phenoxy)phenyl]propane as a thermosetting resin, and agitated for one hour with homomixer to prepare varnish. The resultant varnish was applied on the matte surface of a non-roughened copper foil with a thickness of 12µm (F0-WSfoil, manufactured by Furukawa Circuit Foil Co., Ltd.) with barcorter such that the thickness of the resin composition after dried was 5µm, and dried at 80°C for ten minutes, then at 170°C for another ten minutes, whereby a copper foil with resin composition was produced. Two prepregs each with a thickness of 0.1mm (HL2-832NX(A), manufactured by Mitsubishi Gas Chemical Company, Inc.) were laminated, and on each side of the laminate, the copper foil with resin composition was further laminated such that the resin surfaces face each other. The resultant laminate was pressed under a pressure of 40kgf/cm² at a temperature of 220°C with a vacuum of 30mmHg or less for 110 minutes, whereby a copper-clad laminate with a thickness of about 0.2mm was produced.

### Example 2

The procedure mentioned in Example 1 was followed except that Polyimide 2 prepared in Synthetic Exmaple 2 was used instead of Polyimide 1, whereby a copper-clad laminate with a thickness of about 0.2mm was produced.

### Example 3

The procedure mentioned in Example 1 was followed except that Polyimide 3 prepared in Synthetic Exmaple 2 was used instead of Polyimide 3, whereby a copper-clad laminate with a thickness of about 0.2mm was produced.

### Example 4

The procedure mentioned in Example 1 was followed except that Polyimide 4 prepared in Synthetic Exmaple 4 was used instead of Polyimide 1, whereby a copper-clad laminate with a thickness of about 0.2mm was produced.

### Comparative Example 1

The procedure mentioned in Example 1 was followed except that Comparative Polyimide 1 prepared in Comparative Synthetic Exmaple 1 was used instead of Polyimide 1, whereby a copper-clad laminate with a thickness of about 0.2mm was produced.

### Comparative Example 2

The procedure mentioned in Example 1 was followed except that Comparative Polyimide 2 prepared in Comparative Synthetic Exmaple 2 was used instead of Polyimide 1 in order to produce a copper-clad laminate. However, Comparative Polyimide 2 could not be made into a homogeneous solution, and a copper-clad laminate therefore could not be produced.

### Comparative Example 3

The procedure mentioned in Example 1 was followed except that Comparative Polyimide 3 prepared in Comparative Synthetic Exmaple 3 was used instead of Polyimide 1 in order to produce a copper-clad laminate. However, Comparative Polyimide 3 could not be made into a homogeneous solution, and a copper-clad laminate therefore could not be produced.

### Comparative Example 4

The procedure mentioned in Example 1 was followed except that Comparative Polyimide 4 prepared in Comparative Synthetic Exmaple 4 was used instead of Polyimide 1 in order to produce a copper-clad laminate. However, Comparative Polyimide 4 was semisolid and difficult to handle, and a copper-clad laminate therefore could not be produced.

### Comparative Example 5

The procedure mentioned in Example 1 was followed except that Comparative Polyimide 5 prepared in Comparative Synthetic Exmaple 5 was used instead of Polyimide 1 in order to produce a copper-clad laminate. However, Comparative Polyimide 5 was semisolid and difficult to handle, and a copper-clad laminate therefore could not be produced.

### Comparative Example 6

The procedure mentioned in Example 1 was followed except that the maleimide compound 2,2'-bis[4-(4-maleimide phenoxy)phenyl]propane (used in Example 1 as a thermosetting resin) was not used, and that the amount of Polyimide 1 was changed to 100 parts, whereby a copper-clad laminate with a thickness of about 0.2mm was produced.

### Comparative Example 7

The procedure mentioned in Example 3 was followed except that the maleimide compound 2,2'-bis[4-(4-maleimide phenoxy)phenyl]propane (used in Example 3 as a thermosetting resin) was not used, and that the amount of Polyimide 3 was changed to 100 parts, whereby a copper-clad laminate with a thickness of about 0.2mm was produced.

### <Evaluation of resin compositions>

### (1) Evaluation of handleability of resins

The handleability of a resin were evaluated based on whether a copper-clad laminate can be formed using the resin. The results of evaluation are indicated in Tables 2 and 3. In the tables, "Good" means that a copper-clad laminate could be produced, while "Bad" means that a copper-clad laminate could not be produced.

### (2) Determination of surface roughness after roughening and evaluation of plating copper adhesion

The produced copper-clad laminate was subjected to etching for removing the surface copper foil, and then to desmear treatments (OPC-B103, OPC-1200, OPC-1540MN, and OPC-1300, all of which are manufactured by Okuno Chemical Industries Co., Ltd.: swelling treatment at 65°C for five minutes, etching treatment at 80°C for eight minutes, and neutralizing treatment at 45°C for five minutes). A non-electrolytic copper plating with a thickness of about 0.5 was formed, dried at 130°C for one hour, and measured with a Ultra-high depth color 3D shape measurement microscope (VK-9500, manufactured by Keyence Co.) to determine the Ra value (ten-point average roughness) of the insulating layer surface.

Subsequently, an electrolytic copper plating was formed such that the thickness of the plate copper was 20µm, and then dried at 180°C for one hour. The resultant sample of a laminate with plate copper was measured to evaluate the adhesion strength of plate copper in accordance with JIS C6481. The adhesion strength was determined as an average of three measurements. For samples which swelled by drying after electrolytic copper plating, evaluation was made at an unswelled part thereof. The results of determination of surface roughness after roughening treatment and the results of evaluation of plate copper adhesion are indicated in Tables 2 and 3.

### (3) Evaluation of thermal resistance under moisture absorption

A laminate with plate copper was prepared in the same manner as for the evaluation of plate copper adhesion. The laminate was cut into a 50mm × 50mm piece, plate copper at a half area of one side was removed by etching to prepare a sample. The resultant sample of laminate with plate copper was treated with a pressure cooker testing machine (PC-3 type, manufactured by Hirayama Manufacturing Co.) at 121°C under a pressure of two atmospheres for three hours, then dipped in a plating tab of 260°C for 30 seconds, and observed visually for abnormal changes in appearance (swelling of plate copper) as an indicator for thermal resistance under moisture absorption of resin composition. Evaluation was made using three samples for each resin composition, and each sample was judged as either "Good," which means no change observed, or "Bad," which means that swelling observed. The results of evaluation of thermal resistance under moisture absorption of the resin compositions are indicated in Tables 2 and 3 below.

**[Table 2]**

| Resin composition | Example 1 | Example 2 | Example 3 | Example 4 |
|---|---|---|---|---|
| Handleability of resin | Good | Good | Good | Good |
| Plate copper adhesion (kg/cm) | 0.5 | 0.4 | 0.5 | 0.8 |
| Hydrothermal resistance | Good | Good | Good | Good |
| | Good | Good | Good | Good |
| | Good | Good | Good | Good |
| Surface roughness Ra after roughening (um) | 0.24 | 0.39 | 0.27 | 0.33 |

**[Table 3]**

| Resin composition | Compara -tive Example 1 | Compara -tive Example 2 | Compara -tive Example 3 | Compara -tive Example 4 | Compara -tive Example 5 | Compara -tive Example 6 | Compara -tive Example 7 |
|---|---|---|---|---|---|---|---|
| Handleability of resin | Good | Bad | Bad | Bad | Bad | Good | Good |
| Plate copper adhesion (kg/cm) | 0.1 | - | - | - | - | 0.1 | 0.2 |
| Hydrothermal resistance | Bad | - | - | - | - | Bad | Bad |
| | Bad | | | | | Bad | Bad |
| | Bad | | | | | Bad | Bad |
| Surface roughness Ra after roughening (um) | 0.19 | - | - | - | - | 0.40 | 0.38 |

As is apparent from Tables 2 and 3 above, the insulating layers obtained using the copper-clad laminates with the resin compositions prepared in Examples 1 to 4 (resin compositions of the present invention) were shown to have high plate copper adhesion and high thermal resistance under moisture absorption, despite their low surface roughness after roughening. On the other hand, no copper-clad laminates were produced in Comparative Examples 2 to 5. The insulating layers obtained using the copper-clad laminates with the resin compositions prepared in Comparative Examples 6 and 7 had low surface roughness after roughening, but their adhesion strength of plate copper was weak. In addition, according to the evaluation of thermal resistance under moisture absorption, they caused swelling of the plate copper, being inferior in thermal resistance under moisture absorption.

According to the present invention, a resin composition for use in printed-wiring boards is provided, which is highly soluble and easily handleable, can provide good adhesion to the conducting layer even when the surface roughness is low, and exhibits high thermal resistance under moisture absorption, being suitable for forming fine circuits thereon.

In particular, the present invention can be represented by the following embodiments:
1. A resin composition comprising a polyimide resin, a thermosetting resin, and a filler, the polyimide resin containing a first repeat unit represented by formula (I) and a second repeat unit represented by formula (II) or (III), wherein when the second repeat unit is represented by formula (II), the ratio of the second repeat unit to the polyimide resin is between 5 and 35 mol%, and when the second repeat unit is represented by formula (III), the ratio of the second repeat unit to the polyimide resin is between 5 and 80 mol%. 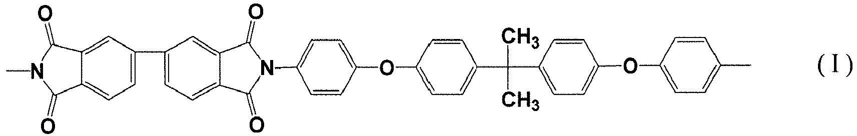 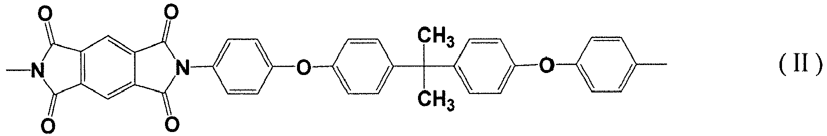 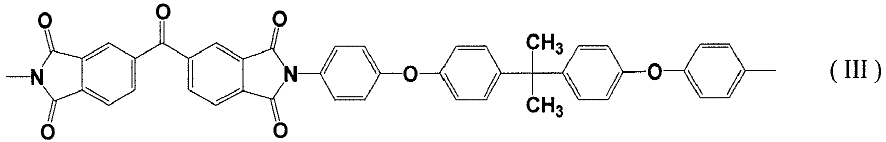
2. The resin composition according to embodiment 1, wherein the thermosetting resin is at least one resin selected from the group consisting of maleimide compounds, epoxy resins, phenol resins, and cyanate resins.
3. The resin composition according to embodiment 1 or 2, wherein the filler is at least one filler selected from the group consisting of silica, aluminum hydroxide, and boehmite.
4. The resin composition according to any one of embodiments 1 to 3, wherein the ratio of the polyimide resin to the total content of the resin composition excluding the filler is between 5 and 90 % by weight.
5. The resin composition according to any one of embodiments 1 to 4, wherein the ratio of the thermosetting resin to the total content of the resin composition excluding the filler is between 10 and 90 % by weight.
6. The resin composition according to any one of embodiments 1 to 5, wherein the ratio of the filler to the total content of the resin composition is between 1 and 60 o by weight.
7. The resin composition according to any one of embodiments 1 to 6, wherein the total ratio of the first and second repeat units to the polyimide resin is 60 mol% or higher.
8. A prepreg comprising a woven or non-woven fabric impregnate with a resin composition according to any one of embodiments 1 to 7.
9. A metallic foil-clad laminate comprising an insulating layer containing a resin composition according to any one of embodiments 1 to 7 and a metallic foil placed over at least one surface of the insulating layer.
10. A printed-wiring board comprising an insulating layer containing a resin composition according to any one of embodiments 1 to 7 and a conducting layer placed over at least one surface of the insulating layer.

## Claims

1. A resin composition comprising a polyimide resin, a thermosetting resin, and a filler, the polyimide resin containing a first repeat unit represented by formula (I) and a second repeat unit represented by formula (III), wherein the ratio of the second repeat unit to the polyimide resin is between 5 and 80 mol%, and wherein the ratio of the thermosetting resin to the total content of the resin composition excluding the filler is between 10 and 90 % by weight.

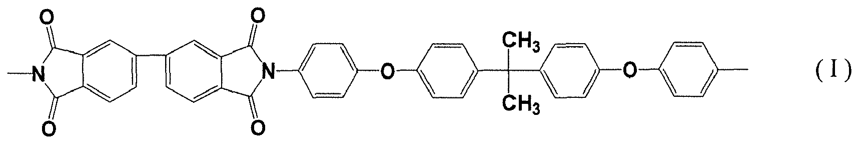

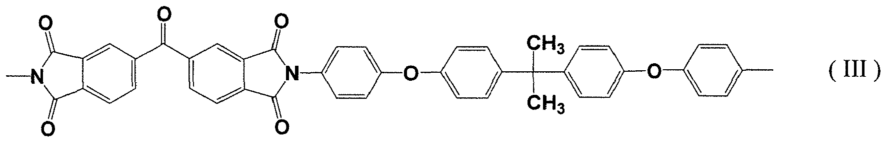

2. The resin composition according to claim 1, wherein the thermosetting resin is at least one resin selected from the group consisting of maleimide compounds, epoxy resins, phenol resins, and cyanate resins.

3. The resin composition according to claim 1 or 2, wherein the filler is at least one filler selected from the group consisting of silica, aluminum hydroxide, and boehmite.

4. The resin composition according to any one of claims 1 to 3, wherein the ratio of the polyimide resin to the total content of the resin composition excluding the filler is between 5 and 90 % by weight.

5. The resin composition according to any one of claims 1 to 4, wherein the ratio of the filler to the total content of the resin composition is between 1 and 60 % by weight.

6. A prepreg comprising a woven or non-woven fabric impregnated with a resin composition according to any one of claims 1 to 5.

7. A metallic foil-clad laminate comprising an insulating layer containing a resin composition according to any one of claims 1 to 5 and a metallic foil placed over at least one surface of the insulating layer.

8. A printed-wiring board comprising an insulating layer containing a resin composition according to any one of claims 1 to 5 and a conducting layer placed over at least one surface of the insulating layer.
